Europäisches Patentamt

European Patent Office

Office européen des brevets

(19)

(11) **EP 1 607 755 A1**

(12) **EUROPEAN PATENT APPLICATION**

(43) Date of publication:
**21.12.2005 Bulletin 2005/51**

(51) Int Cl.[7]: **G01R 27/14**

(21) Application number: **04392032.1**

(22) Date of filing: **14.06.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(71) Applicant: **Dialog Semiconductor GmbH
73230 Kirchheim (DE)**

(72) Inventor: **Arigliano, Antonello
82110 Germering (DE)**

(74) Representative: **Schuffenecker, Thierry
97, chemin de Cassiopée,
Domaine de l'étoile
06610 La Gaude (FR)**

(54) **Very precise resistance measurement**

(57)     A circuit and a related method to measure very precisely the resistance Rm of a small resistor independent from process and temperature variations. This resistor may be the RON resistance of an external sensor or e.g. the resistance of a safety device as a squib. A constant current source provides a current IBIAS causing a voltage drop Vm at the resistor to be measured. Using a configuration of operational amplifiers and current mirrors, wherein one of the current mirrors has a gain of n, an output voltage VOUT is achieved, which is defined by VOUT = n x Rm x IBIAS. The gain n of a current mirror allows a very precise measurement of the resistance Rm of the resistor to be measured. The output voltage is finally converted from analog to digital values.

FIG. 1

EP 1 607 755 A1

## Description

### Field of the Invention

This invention relates generally to electrical resistance measurement and relates more particularly to a very precise measurement of the resistance of small resistors using a semiconductor circuit.

### Background art

Monitoring the resistance regularly of e.g. external sensors or of safety devices as squibs for airbags or other devices for automotive or aviation applications is an important task. This measurement must be reliable, precise and fast and it may not impede the normal application of the sensor, or resistor whatever. This measurement has often to be performed almost constantly in short time intervals.

A challenge to the designers of electronic circuits is to find an efficient solution to measure the resistance of such devices periodically. There are various patents available dealing amongst other purposes with the measurement of resistances.

U. S. Patent (6,133,749 to Hansen et al.) describes a programmable variable impedance output driver circuit using analog biases to match driver output impedance to load input impedance. A current mirror is used to obtain a measurement of an external resistance value for matching the impedance of a driven load. The mirrored current generates the voltage "NBIAS" when passed through the resistively connected NFET. Similarly, the current is again mirrored and passed through a resistively connected PFET resulting in the voltage "PBIAS". The analog bias voltages, NBIAS and PBIAS are used to vary the impedance of complementary FETs in an impedance matched driver for a high degree of dI/dt control. The driver provides a high degree of flexibility because its turn-on and turn-off characteristics do not depend on a combination of digital control signals connected directly to the driving FETs as in the prior art. Instead, the PBIAS and NBIAS signals provide analog controls which may be applied to single transistors whose impedance changes as PBIAS and NBIAS increase or decrease.

U. S. Patent (6,498,494 to Belau et al.) discloses how the resistance value and the leakage current of a load can be measured simultaneously. A load current is fed, mirrored by electrical power supplies into a resistance measuring circuit and a leakage current measuring circuit. This permits rapid, precise measurement of a plurality of loads by a single measuring circuit connected via one multiplexer. The firing transistors can be distributed among different ASICs or provided jointly for a plurality of firing caps.

## Summary of the invention

A principal objective of the present invention is to achieve a circuit to measure very precisely the resistance Rm of a small resistor independent from process and temperature variations.

A principal objective of the present invention is to achieve a method to measure very precisely the resistance Rm of a small resistor independent from process and temperature variations.

In accordance with the objects of this invention a circuit to measure very precisely the resistance of a small resistor independent from process and temperature variations has been achieved. Said circuit comprises, firstly, a constant current source, a resistor to be measured, wherein a first terminal of the resistor is connected to said current source, to a first input of a third means to clamp voltage and via a switch to any application circuitry, and a second terminal is connected to a first means to clamp voltage and via another switch to an application circuitry, wherein said both switches are open during a resistance measurement of the resistor, and a pair of switching means, wherein each of the switching means is between one terminal of said resistor to be measured and a circuitry of any application. Furthermore said circuit comprises a first means to clamp voltage, having two inputs and an output, wherein the first input is a reference voltage and the second input is a feedback from the output of said means to clamp voltage and wherein the current provided by said current source is flowing through the first means to clamp a voltage to ground and its output is connected to a first input of a second means to clamp a voltage, a second means to a clamp a voltage having two inputs and an output, wherein the first input is the output of said first means to clamp a voltage and the second input is a feedback from its own output and it is generating at its output a current $I_1$ flowing from $V_{DD}$ voltage through a first resistor to ground. Furthermore said circuit comprises a first, a second and a third resistor all having the same resistance, a first current mirror comprising a first and a second PMOS transistor, having both the same size, mirroring said current $I_1$, and a third means to clamp a voltage having two inputs and an output, wherein the first input connected to a first terminal of said resistor to be measured and the second input is a feedback from its own output and it is generating at its output a current $I_3$ flowing from $V_{DD}$ voltage and a current $I_2$ through a second resistor to ground, wherein $I_2$ and $I_3$ are connected to the mirrored current $I_1$ in a way that $I_3$ plus $I_1$ equals $I_2$. Finally said circuit comprises a current mirror comprising a first and a second PMOS transistor, having a gain n, mirroring said current $I_3$, wherein the size of the second PMOS transistor is n-times larger than the size of the first transistor, and wherein a mirrored current $I_4$ is generated, amplified by the gain n, flowing via the third resistor to ground and providing an analog output voltage, and an analog-to digital converter converting said output voltage to digital values.

In accordance with the objects of this invention a method to measure very precisely the resistance of a small resistor independent from process and temperature variations has been achieved. Said method comprises, firstly, providing a resistor Rm to be measured, a reference voltage $V_{REF}$, and a circuit comprising a constant current source, a pair of switching means, a number of means to clamp a voltage, a number of current mirrors, wherein at least one current mirror has a gain of n, a number of resistors having all the same value R, and a analog-to digital converter. The next step of the method invented are to disconnect resistor Rm from its application circuitry, to provide a constant current $I_{BIAS}$ through the resistor Rm to be measured causing a voltage drop Vm, and to generate a current $I_1$ defined by $I_1 = \frac{V_{REF}}{R}$. The following steps of the method invented are to generate a current $I_2$ defined by $I_2 = \frac{V_{REF} + V_m}{R}$, to generate a current $I_3$ which is defined by $I_3 = I_2 - I_1 = \frac{V_m}{R}$, to generate a current $I_4$ defined by $I_4 = n \times I_3$ causing a voltage drop Vout = n x Rm x $I_{BIAS}$, and to convert $V_{OUT}$ from analog to digital values.

**Description of the drawings**

In the accompanying drawings forming a material part of this description, there is shown:

> **Fig. 1** shows a schematic of the circuit of the present invention.

> **Fig. 2** illustrates a flowchart of a method to measure very precisely the resistance Rm of a small resistor.

**Description of the preferred embodiment**

The preferred embodiments disclose a novel circuit and a related method to measure very precisely the resistance of a small resistor independent from process and temperature variations.
In many applications the resistance of external sensors or safety devices as e.g. a squib needs to be monitored.

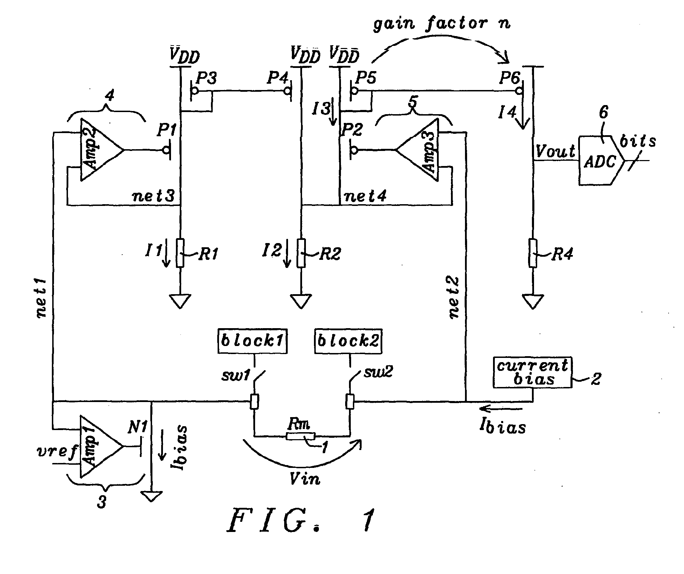

**Fig. 1** shows a principal schematic of a preferred embodiment of the present invention. It comprises the resistor **Rm 1** to be measured, two switches **Sw1** and **Sw2** and **block1** and **block2**. **Block 1** and **block 2** symbolize the circuitry of any application using resistor **Rm 1** which has to be monitored regularly. **Rm 1** could e.g. represent the Ron resistance of an external sensor or the resistance of a squib device or any other safety device. During the timeframe the application blocks **1** and **2** are in operation mode switches **Sw1** and **Sw2** are closed and all the other blocks of the circuit shown are turned off. This means in this operation mode the current source **2** is turned off and hence the current $I_{BIAS}$ is zero.
Furthermore the circuit of **Fig. 1** comprises three amplifier configurations **3, 4,** and **5.** Their main purpose is to clamp voltage levels. The amplifier configuration **3** comprises the operational amplifier **AMP1** and at its output the NMOS transistor **N1,** amplifier configuration **4** comprises the operational amplifier **AMP2** and at its output the PMOS transistor **P1,** and amplifier configuration **4** comprises the operational amplifier **AMP3** and at its output the PMOS transistor **P2.** The operational amplifier **AMP1** has two inputs, a reference voltage $V_{REF}$ and a feedback loop from **N1.** The PMOS transistors **P1** and **P2** have the same size.
During the timeframe the resistance of **Rm 1** is measured switches **Sw1** and **Sw2** are open and the current source block **2,** amplifiers **Amp 1, Amp 2,** and **Amp3** are all enabled and current $I_{BIAS}$ is flowing through **Rm 1,** causing the voltage drop **Vm,** and through NMOS transistor **N1.** The current source block **2** provides a constant current $I_{BIAS}$, which is independent from process and temperature variations. In a preferred embodiment of the invention a current mirror configuration has been used to implement such a current source. Due to the infinite high input resistance of the operational amplifiers **Amp1** and **Amp2** the current $I_{BIAS}$ flows through **Rm 1** and transistor **N1.** The voltage drop **Vm** is defined by:

$$Vm = Rm \times I_{BIAS}. \qquad (1)$$

During the measurement phase the operational amplifier **Amp1** and transistor **N1** clamp the voltage level at **net1** to the level of the reference voltage $V_{REF}$ and they clamp the voltage level at **net2** to the level **VREF+ Vm,** this means to the sum of the reference voltage at **Amp1** and of the voltage drop at **Rm 1.**
The operational amplifier **Amp2** has two inputs, the voltage level of **net1** and a feedback loop from the PMOS transistor **P1.** Therefore the operational amplifier **Amp2** and transistor **P1** clamp the voltage level at **net3** to the level of the reference voltage **VREF** during the measurement phase and thus causing a current $I_1$ to flow through the resistor **R1:**

$$I_1 = \frac{V_{REF}}{R_1}.$$

The PMOS transistors **P3** and **P4** are connected in a current mirror configuration. They have both the same size and hence the same current $I_1$ is flowing through transistors **P3** and **P4.**
The operational amplifier **Amp3** and transistor **P2** clamp the voltage level at **net4** to the level $V_{REF+}$ $V_m$, this means to the sum of the reference voltage at **Amp1** and the voltage drop at $R_m$ **1** and thus causing a current $I_2$ to flow through the resistor **R2**:

$$I_2 = \frac{V_M + V_{REF}}{R_2} .$$

Resistors **R1** and **R2** are resistors of the same size and material and have both the resistance **R**.

Another current mirror is formed by the PMOS transistors **P5** and **P6**. The channel-width of **P6** is n-times larger than the channel-width of **P5** while they have both the same channel-length. Therefore this current mirror has a current gain of the factor **n.**

The current $I_3$ flowing through **P5,** this means a first branch of the **P5/P6** current mirror is defined by

$$I_3 = I_2 - I_1 = \frac{V_M + V_{REF}}{R_2} - \frac{V_{REF}}{R_1} ,$$

wherein

$$R2 = R1 = R.$$

$I_3$ is defined by:

$$I_3 = \frac{V_M}{R} \qquad (2).$$

The current $I_4$, flowing through transistor **P6** in the second leg of the **P5/P6** current mirror, is defined by amplification of current $I_3$ by the current gain factor **n** of the **P5/P6** current mirror:

$$I_4 = n \times I_3.$$

The current $I_4$ is flowing through resistor **R4,** which has the same resistance value **R** as resistors **R1** and **R2.** The output voltage $V_{OUT}$ is defined by $V_{OUT} = R \times I_4 = R \times n \times I_3$ or using equations (1) and (2)

$$V_{OUT} = n \times Rm \times I_{BIAS}, \qquad (3)$$

wherein **n** and $I_{BIAS}$ are well-known parameters. Finally equation (3) can be modified to calculate the resistance **Rm:**

$$R_m = \frac{V_{OUT}}{n \times I_{BIAS}}.$$

For further processing the value of $V_{OUT}$ is converted from analog to digital values by the analog-to-digital converter **6.**

In the preferred embodiment all components of the circuit invented, with the exception of the resistor to be measured of course, have been integrated in an IC.

The circuit described above could be implemented alternatively by interchanging all NMOS transistors by PMOS transistors and vice versa and by interchanging $V_{DD}$ voltage and ground voltage.

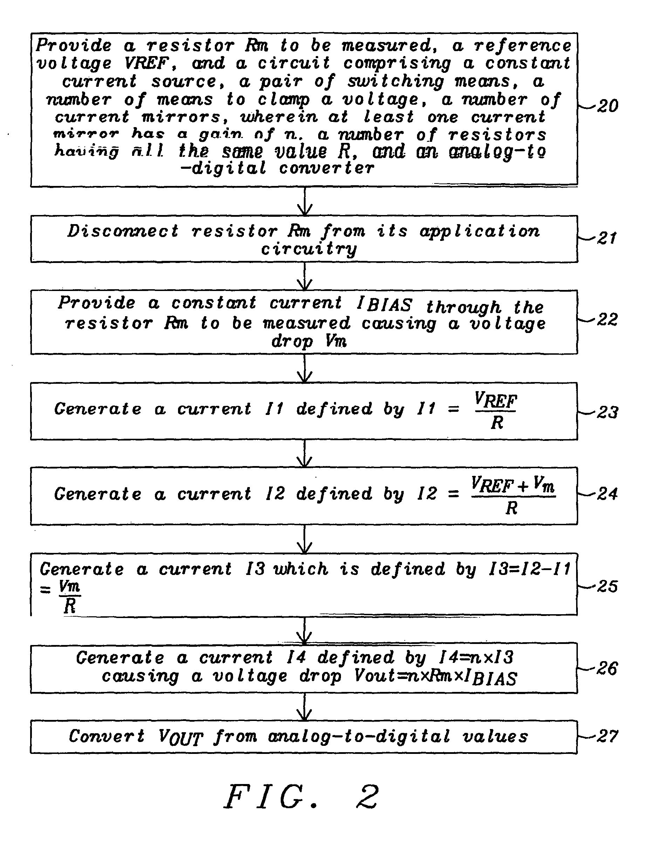

**Fig. 2** shows a flowchart of the principal steps of a method to measure very precisely the resistance of a small resistor independent from process and temperature variations. The first step **20** illustrates the provision of a resistor Rm to be measured, a reference voltage $V_{REF}$, and a circuit comprising a constant current source, a pair of switching means, a number of means to clamp a voltage level, a number of current mirrors, wherein at least one current mirror has a gain of n, a number of resistors having all the same value R, and an analog-to digital converter.

In the next step **21** the resistor Rm is disconnected electrically from its application circuitry. In the following step **22** a constant current $I_{BIAS}$ is provided through the resistor Rm to be measured causing a voltage drop Vm and the next step **23** describes the generation of a current $I_1$ defined by $I_1 = \frac{V_{REF}}{R}$. In the following step **24** another current $I_2$ defined by $I_2 = \frac{V_{REF} + V_m}{R}$ is generated and in step **25** a further current $I_3$, which is defined by $I_3 = I_2 - I_1 = \frac{V_m}{R}$, is generated. Furthermore in step **26** a current $I_4$ defined by $I_4 = n \times I_3$ causing a voltage drop Vout = n x Rm x $I_{BIAS}$ is generated. In the last step **27** the voltage $V_{OUT}$ is converted from analog to digital values for further processing. As explained above the value of Rm can be deducted easily because the parameters $I_{BIAS}$ and the current gain n are known.

While the invention has been particularly shown and described with reference to the preferred embodiments thereof, it will be understood by those skilled in the art that various changes in form and details may be made without departing from the spirit and scope of the invention.

**Claims**

1. A circuit to measure very precisely the resistance of a small resistor independent from process and temperature variations is comprising:

   - a constant current source;
   - a resistor to be measured, wherein a first terminal of the resistor is connected to said current source, to a first input of a third means to clamp voltage and via a switch to any application circuitry, and a second terminal is connected to a first means to clamp voltage and via another switch to an application circuitry, wherein said both switches are open during a resistance measurement of the resistor;

- a pair of switching means, wherein each of the switching means is between one terminal of said resistor to be measured and a circuitry of any application;

a first means to clamp voltage having two inputs and an output, wherein the first input is a reference voltage and the second input is a feedback from the output of said means to clamp voltage and wherein the current provided by said current source is flowing through the first means to clamp a voltage to ground and its output is connected to a first input of a second means to clamp a voltage;

- a second means to a clamp a voltage having two inputs and an output, wherein the first input is the output of said first means to clamp a voltage and the second input is a feedback from its own output and it is generating at its output a current $I_1$ flowing from VDD voltage through a first resistor to ground;
- a first, a second and a third resistor all are having the same resistance;
- a first current mirror comprising a first and a second PMOS transistor, having both the same size, mirroring said current $I_1$;
- a third means to clamp a voltage having two inputs and an output, wherein the first input connected to a first terminal of said resistor to be measured and the second input is a feedback from its own output and it is generating at its output a current $I_3$ flowing from VDD voltage and a current $I_2$ through a second resistor to ground, wherein $I_2$ and $I_3$ are connected to the mirrored current $I_1$ in a way that $I_3$ plus $I_1$ equals $I_2$;
- a current mirror comprising a first and a second PMOS transistor, having a gain n, mirroring said current $I_3$, wherein the size of the second PMOS transistor is n-times larger than the size of the first transistor, and wherein a mirrored current $I_4$ is generated, amplified by the gain n, flowing via the third resistor to ground and providing an analog output voltage; and
- an analog-to digital converter converting said output voltage to digital values.

2. The circuit of claim 1 wherein all NMOS transistors are replaced by PMOS transistors and all PMOS transistors are replaced by NMOS transistors.

3. The circuit of claim 1 wherein said pair of switching means is a pair of transistors.

4. The circuit of claim 1 wherein said first means to clamp a voltage comprises an NMOS transistor and an operational amplifier having two inputs and an output, wherein the first input is a reference voltage and the second input is connected to the drain of the NMOS transistor and the output is connected to the gate of the NMOS transistor and wherein the source of the NMOS transistor is connected to ground and the drain is further connected to the second terminal of said resistor to be measured and to a first input of said second means to clamp a voltage.

5. The circuit of claim 1 wherein said second means to clamp a voltage comprises a PMOS transistor and an operational amplifier having two inputs and an output, wherein the first input is connected to the output of said first means to clamp a voltage and the second input is connected to the drain of the PMOS transistor and to a first terminal of said first resistor and the output is connected to the gate of the PMOS transistor and wherein the drain of the PMOS transistor is connected to the first terminal of the first resistor and the source is connected to the gate and to the drain of said first transistor of said first current mirror.

6. The circuit of claim 1 wherein said third means to clamp a voltage comprises an PMOS transistor and an operational amplifier having two inputs and an output, wherein the first input is connected to the first terminal of said resistor to be measured and the second input is connected to the drain of the PMOS transistor and to a first terminal of said second resistor and the output is connected to the gate of the PMOS transistor and wherein the drain of the PMOS transistor is connected to the first terminal of the second resistor and the source is connected to the gate and to the drain of said first transistor of said second current mirror.

7. The circuit of claim 1 wherein said constant current source is comprising a current mirror configuration.

8. The circuit of claim 1 wherein said circuit is integrated on an IC.

9. A method to measure very precisely the resistance of a small resistor independent from process and temperature variations is comprising:

- providing a resistor Rm to be measured, a reference voltage $V_{REF}$, and a circuit comprising a constant current source, a pair of switching means, a number of means to clamp a voltage, a number of current mirrors, wherein at least one current mirror has a gain of n, a number of resistors having all the same value R, and a analog-to digital converter;

- disconnect resistor Rm from its application circuitry;

- provide a constant current $I_{BIAS}$ through the resistor Rm to be measured causing a voltage drop Vm;

- generate a current $I_1$ defined by $I_1 = \dfrac{V_{REF}}{R}$ ;

- generate a current $I_2$ defined by $I_2 = \dfrac{V_{REF} + Vm}{R}$ ;

- generate a current $I_3$ which is defined by $I_3 = I_2 - I_1 = \dfrac{V_m}{R}$;

- generate a current $I_4$ defined by $I_4 = n \times I_3$ causing a voltage drop Vout = n x Rm x $I_{BIAS}$; and

- convert $V_{OUT}$ from analog to digital values.

10. The method of claim 9 wherein said current $I_1$ is generated by voltage clamping of the reference voltage $V_{REF}$.

11. The method of claim 9 wherein said current $I_2$ is generated by voltage clamping of the sum of the reference voltage $V_{REF}$ and the voltage drop Vm.

12. The method of claim 9 wherein a current mirrored from $I_1$ in the scale of 1:1 is used to get the current $I_3$ by subtraction of $I_2$ from said current mirrored from $I_1$.

13. The method of claim 9 wherein said current $I_4$ is generated by mirroring current $I_3$ using a mirroring scale of n.

F I G. 1

EP 1 607 755 A1

Provide a resistor Rm to be measured, a reference voltage VREF, and a circuit comprising a constant current source, a pair of switching means, a number of means to clamp a voltage, a number of current mirrors, wherein at least one current mirror has a gain of n, a number of resistors having all the same value R, and an analog-to-digital converter — 20

Disconnect resistor Rm from its application circuitry — 21

Provide a constant current $I_{BIAS}$ through the resistor Rm to be measured causing a voltage drop Vm — 22

Generate a current I1 defined by $I1 = \dfrac{V_{REF}}{R}$ — 23

Generate a current I2 defined by $I2 = \dfrac{V_{REF} + V_m}{R}$ — 24

Generate a current I3 which is defined by $I3 = I2 - I1 = \dfrac{V_m}{R}$ — 25

Generate a current I4 defined by $I4 = n \times I3$ causing a voltage drop $V_{out} = n \times R_m \times I_{BIAS}$ — 26

Convert $V_{OUT}$ from analog-to-digital values — 27

FIG. 2

8

European Patent Office

**EUROPEAN SEARCH REPORT**

Application Number

EP 04 39 2032

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | US 6 498 494 B2 (BELAU HORST ET AL) 24 December 2002 (2002-12-24) * column 6, line 20 - column 9, line 55; figure 1 * | 1-13 | G01R27/14 |
| A | EP 0 701 928 A (FORD MOTOR CO) 20 March 1996 (1996-03-20) * abstract; figure 1 * | 1-13 | |
| A | EP 0 454 012 A (ABB PATENT GMBH) 30 October 1991 (1991-10-30) * abstract; figure 1 * | 1-13 | |
| D,A | US 6 133 749 A (PILO HAROLD ET AL) 17 October 2000 (2000-10-17) * column 3, line 19 - line 59; figure 2 * | 1-13 | |

|  |
|---|
| TECHNICAL FIELDS SEARCHED (Int.Cl.7) |
| G01R |

The present search report has been drawn up for all claims

| Place of search | Date of completion of the search | Examiner |
|---|---|---|
| The Hague | 22 November 2004 | Koll, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 39 2032

This annex lists the patent family members relating to the patent documents cited in the above-mentioned European search report.
The members are as contained in the European Patent Office EDP file on
The European Patent Office is in no way liable for these particulars which are merely given for the purpose of information.

22-11-2004

| Patent document cited in search report | | Publication date | Patent family member(s) | | Publication date |
|---|---|---|---|---|---|
| US 6498494 | B2 | 20-12-2001 | DE | 59902212 D1 | 05-09-2002 |
| | | | WO | 0014555 A1 | 16-03-2000 |
| | | | EP | 1112504 A1 | 04-07-2001 |
| | | | JP | 2002524742 T | 06-08-2002 |
| | | | US | 2001052777 A1 | 20-12-2001 |
| EP 0701928 | A | 20-03-1996 | US | 5541523 A | 30-07-1996 |
| | | | EP | 0701928 A1 | 20-03-1996 |
| EP 0454012 | A | 30-10-1991 | DE | 4013490 A1 | 31-10-1991 |
| | | | CS | 9101182 A2 | 12-11-1991 |
| | | | EP | 0454012 A2 | 30-10-1991 |
| | | | HR | 920937 A1 | 31-10-1995 |
| | | | SI | 9110278 A | 31-12-1995 |
| US 6133749 | A | 17-10-2000 | NONE | | |

EPO FORM P0459

For more details about this annex : see Official Journal of the European Patent Office, No. 12/82